# EUROPÄISCHE PATENTSCHRIFT

(11) **EP 0 740 794 B1**
(45) Veröffentlichungstag und Bekanntmachung des Hinweises auf die Patenterteilung: **24.03.1999**
(21) Anmeldenummer: 95905530.2
(22) Anmeldetag: 10.01.1995
(51) Int. Cl.: G01P 15/08

(54) **VERFAHREN ZUR HERSTELLUNG EINES BESCHLEUNIGUNGSSENSORS**
PROCESS FOR PRODUCING AN ACCELERATION SENSOR
PROCEDE POUR LA FABRICATION D'UN DETECTEUR D'ACCELERATION

(30) Priorität: 18.01.1994 DE 4401304
(43) Veröffentlichungstag der Anmeldung: 06.11.1996
(73) Patentinhaber: SIEMENS AKTIENGESELLSCHAFT, 80333 München (DE)
(72) Erfinder: KLOSE, Helmut, D-81929 München (DE); BIEBL, Markus, D-86163 Augsburg (DE); SCHEITER, Thomas, D-80469 München (DE); HIEROLD, Christopher, D-81739 München (DE)
(86) Internationale Anmeldenummer: DE9500022
(87) Internationale Veröffentlichungsnummer: WO9519572

(56) Entgegenhaltungen:
- US-A- 4 918 032
- US-A- 5 241 864
- THIN SOLID FILMS, Bd. 220,Nr. 1/2, 1992 LAUSANNE, Seiten 106-110, XP 000354480 RISTIC ET AL 'PROPERTIES OF POLYSILICON FILMS ANNEALED BY A RAPID THERMAL ANNEALING PROCESS.'
- IEEE TRANSACTIONS ON ELECTRON DEVICES, Bd. ED-29,Nr. 1, 1.Januar 1992 NEW YORK, Seiten 23-27, PETERSEN ET AL 'MICROMECHANICAL ACCELEROMETER INTEGRATED WITH MOS DETECTION CIRCUITRY.'
- 1990 IEEE INTERNATIONAL SYMPOSIUM ON CIRCUITS AND SYSTEMS, Bd. 4, 1.Mai 1990 - 3.Mai 1990 SHERATON HOTEL NEW ORLEANS, Seiten 3085-3088, XP 000163491 POLLA ET AL 'INTEGRATED GAAS MICROSENSORS; 90 CH2868-8'

## Beschreibung

Die vorliegende Erfindung betrifft ein Herstellungsverfahren für Beschleunigungssensoren in Silziumtechnik, bei dem mikromechanische Herstellungsmethoden zur Anwendung gelangen.

Äußerst kleine und damit kosteneffiziente mikromechanische Beschleunigungssensoren für Beschleunigungsmessungen im Bereich von Erdbeschleunigungen erfordern für die Auswertung des Meßergebnisses elektronische Schaltungen. Derartige intelligente Sensoren werden üblicherweise in Hybrid-Aufbau hergestellt, weil eine Realisierung in demselben Substrat eine praktisch additive Herstellungstechnologie erforderlich macht. Die elektronische Schaltung und der mikromechanische Sensor werden nacheinander hergestellt, so daß üblicherweise ein derartiger integierter Sensoren mehr als vier Zusatzmasken bei der Herstellung erfordert, was einen Mehraufwand von mindestens 20% verursacht.

Aus US-A-5 241 864 ist eine Sensoranordnung bekannt, bei der auf einem Substrat Schaltungskomponenten erzeugt sowie in einem späteren Produktionsschritt eine bewegliche Struktur aus Polysilizium aufgebracht werden.

Aufgabe der vorliegenden Erfindung ist es, ein günstiges Herstellungsverfahren für einen mikromechanischen Beschleunigungssensor mit Elektronik anzugeben.

Diese Aufgabe wird mit dem Verfahren mit den Merkmalen des Anspruches 1 gelöst. Weitere Ausgestaltungen ergeben sich aus den abhängigen Ansprüchen.

Bei dem erfindungsgemäßen Herstellungsverfahren kommt die Technik der Herstellung mikromechanischer Strukturen in Silizium zur Anwendung. Die elektronischen Schaltungen werden in Siliziumtechnik, insbesondere in Bipolartechnik oder CMOS-Technik in Silizium, hergestellt. Das erfindungsgemäße Herstellungsverfahren läßt sich mit allen Herstellungsverfahren elektronischer Bauelemente in Silizium kombinieren, bei denen eine oder zwei Polysiliziumschichten aufgebracht werden. Es können Sensoren hergestellt werden, bei denen das Sensorelement durch ein in mindestens einer Richtung zumindest teilweise bewegliches Siliziumteil gebildet wird. Insbesondere läßt sich das erfindungsgemäße Verfahren zur Herstellung von Beschleunigungssensoren mit freitragendem Polysiliziumstreifen (Cantilever-Sensor-Typen) anwenden. Die Vereinfachung bei der Herstellung resultiert daraus, daß mindestens eine Polysiliziumschicht für einen Transistor und das Sensorelement gemeinsam abgeschieden und strukturiert wird. Aus dieser Polysiliziumschicht werden mindestens eine Transistorelektrode und eine räumlich begrenzte Sensorschicht als bewegliches Sensorelement hergestellt. Bei Anwendung eines Doppel-Polysilizium-Prozesses kann vorher noch eine weitere Polysiliziumschicht aufgebracht werden, die strukturiert eine weitere Transistorelektrode und eine für die Beschleunigungsmessung vorgesehene Gegenelektrode bildet.

Es folgt eine Beschreibung des erfindungsgemaßen Herstellungsverfahrens anhand der Figuren 1 bis 15.

Fig. 1 bis 4 zeigen Ausführungsbeispiele von erfindungsgemäß hergestellten Sensoren im Querschnitt.

Fig. 5 zeigt die in Fig. 2 eingezeichnete Ansicht.

Fig. 6 bis 11 zeigen Sensoren im Querschnitt nach verschiedenen Schritten des zu der in Fig. 1 gezeigten Struktur führenden Verfahrens.

Fig. 12 zeigt den Beschleunigungssensor nach einem zu der in

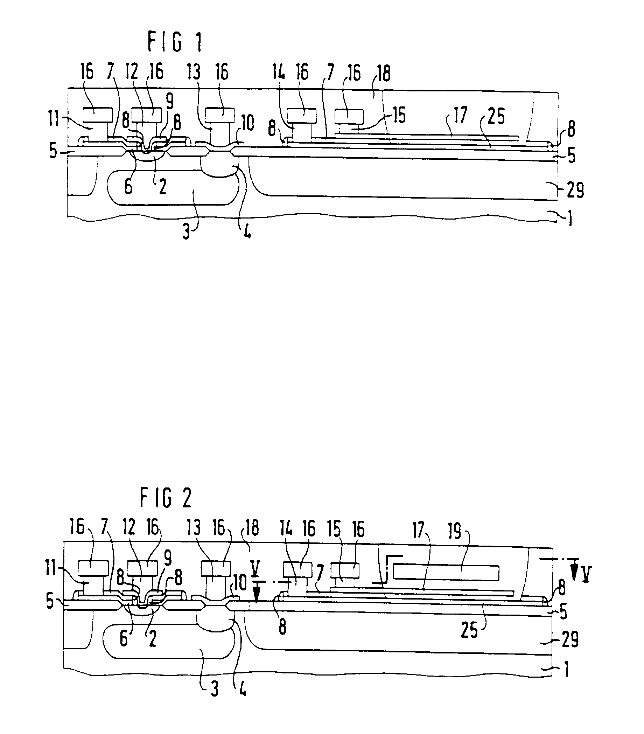

Fig. 2 dargestellten Struktur führenden Herstellungsschritt.

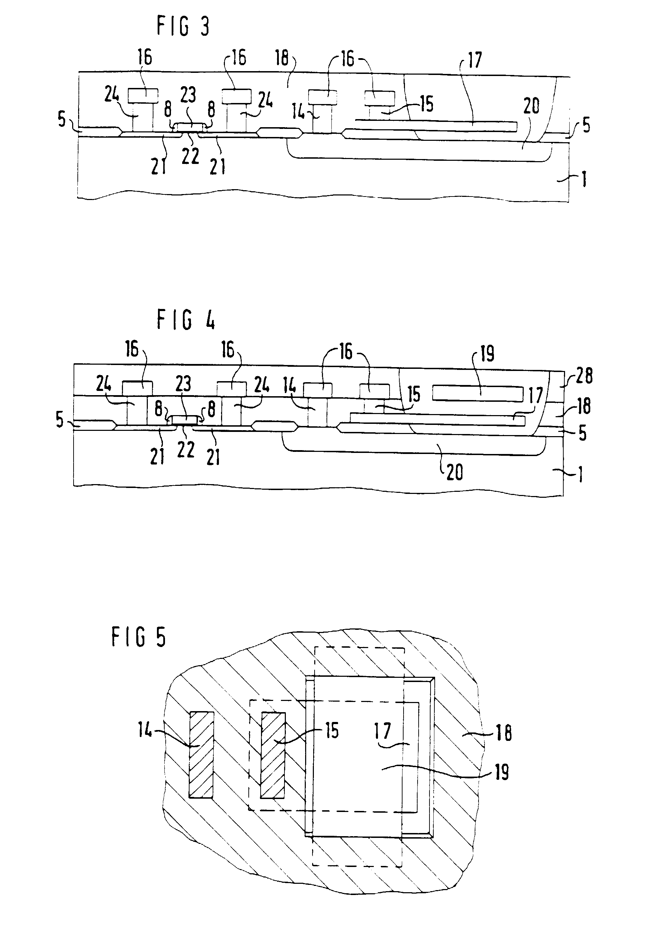

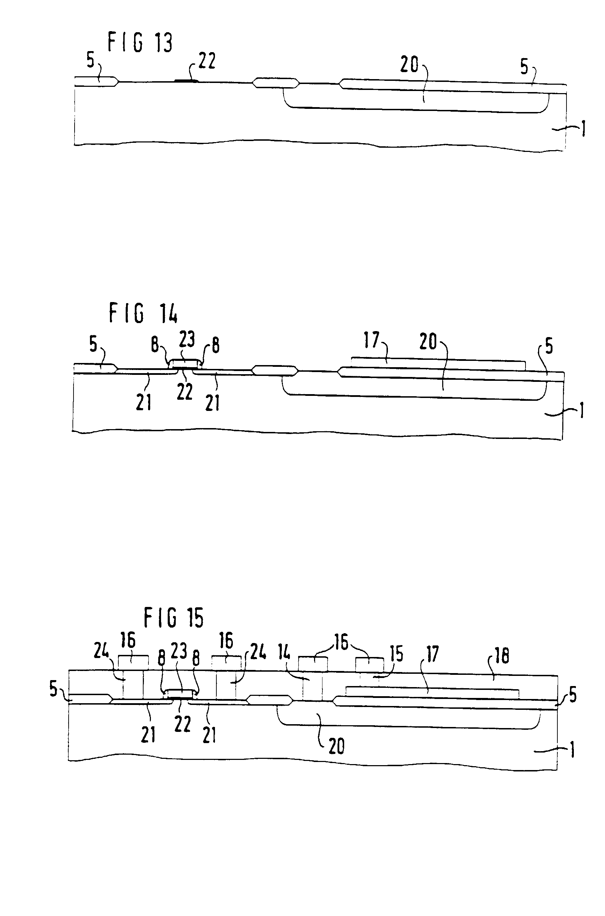

Fig. 13 bis 15 zeigen einen Beschleunigungssensor im Querschnitt nach verschiedenen Schritten der Herstellung einer der in Figuren 3 oder 4 gezeigten Strukturen.

Es wird zunächst ein Einfach-Polysilizium-Prozeß zur Herstellung des Beschleunigungssensors beschrieben. Bei einem derartigen Verfahren wird nur eine Polysiliziumschicht abgeschieden, aus der eine Transistorelektrode und die bewegliche Sensorschicht strukturiert werden. Auf diese Weise lassen sich z. B. die in den Figuren 3 und 4 dargestellten Sensoren herstellen. In Fig. 3 ist auf einer Substratschicht 1 aus Silizium ein CMOS-Transistor hergestellt. Die Source- und Drain-Bereiche 21 flankieren den mit dem Gateoxid 22 versehenen Kanalbereich. Auf dem Gateoxid 22 befindet sich die von Spacern 8 begrenzte Gateelektrode 23 aus Polysilizium. Ebenfalls Polysilizium ist die Sensorschicht 17, die einen freitragend verankerten Streifen als Cantilever bildet. Dieser Streifen wird bei Beschleunigung in zur Schichtebene vertikaler Richtung ausgelenkt. Für die Messung ist eine Gegenelektrode erforderlich, die als weitere Sensorelektrode 20 unterhalb dieser Sensorschicht 17 angeordnet ist. Für diese weitere Sensorelektrode 20 und die Sensorschicht 17 sind Metallisierungen 14, 15 vorhanden. Außerdem sind Source- und Drain-Metallisierungen 24 sowie Anschlußmetallisierungen 16 als Leiterbahnen vorhanden. Als Isolation der verschiedenen dotierten Bereiche fungiert die strukturierte Oxidschicht 5. Bei dem Ausführungsbeispiel der Fig. 4 ist zusätzlich eine obere Sensorelektrode 19 vorgesehen, die in der Senkrechten zur Zeichenebene zwischen einer Dielektrikumschicht 18 und einer Passivierungsschicht 28 verankert ist.

Die für diesen Beschleunigungssensor mögliche Ausführungsform des Herstellungsverfahrens geht von einer Substratschicht 1 aus Silizium aus. Es kann sich entweder um ein Substrat oder um eine Siliziumschicht auf einem Substrat handeln. Es kann auch die Siliziumschicht eines SOI-Substrates sein. Durch Implantation werden die für einen CMOS-Transistor erforderlichen dotierten Bereiche (CMOS-Wannen) hergestellt. Ggf. kann unter Verwendung der dafür hergestellten Justiermarken eine zusätzliche hoch dotierte Schicht eingebracht werden, welche später als Gegenelektrode (weitere Sensorelektrode) für den Sensor dient. Diese zusätzliche Dotierung ist nur in dem Fall notwendig, daß der Zuleitungswiderstand der CMOS-n-Wanne nicht niedrig genug ist, um eine hinreichend genaue Kapazitätsmessung für die Auswertung der Beschleunigung durchführen zu können. Die Oberseite der Substratschicht 1 kann z. B. durch strukturierte Oxidation in eine Oxidschicht 5 umgewandelt werden, die an den für den Transistor und den Anschluß der weiteren Sensorelektrode 20 vorgesehenen Stellen Öffnungen aufweist. Nach dem Aufbringen des Gateoxids 22 ist der in Fig. 13 dargestellte Aufbau realisiert. Es wird dann ganzflachig eine für das erfindungsgemäße Verfahren wesentliche Polysiliziumschicht aufgebracht. Nach dem Strukturieren dieser Schicht verbleiben davon die Gateelektrode 23 und die für das bewegliche Sensorelement vorgesehene Sensorschicht 17. Diese Sensorschicht 17 befindet sich vollständig auf der Oxidschicht 5 und ist daher von dem restlichen Silizium getrennt. Unter Verwendung von wie üblich hergestellten Spacern 8 werden die Source- und Drain-Bereiche 21 für den Transistor hergestellt, so daß sich die Struktur der Fig. 14 ergibt.

Es wird ganzflächig eine Dielektrikumschicht 18 planarisierend aufgebracht, in der an den für die Kontaktierung vorgesehenen Stellen Kontaktlöcher hergestellt werden. Diese Kontaktlöcher können z. B. mit Metall (z. B. Wolfram) gefüllt werden, bevor die erste Metallisierungsebene aufgebracht wird. Die Kontaktlöcher können aber auch zusammen mit dem Aufbringen dieser Anschlußmetallisierung 16 aufgefüllt werden, so daß die Source- und Drain-Bereiche 21 mit Source- und Drain-Metallisierungen 24 versehen sind, und die als Gegenelektrode vorgesehene weitere Sensorelektrode 20 mit einer betreffenden Metallisierung 14 und die Sensorschicht 17 mit einer betreffenden Metallisierung 15 kontaktiert sind. Die in Fig. 15 dargestellte Struktur wird dann mit einer Passivierung bedeckt, die dann im Bereich des Sensors zusammen mit der Dielektrikumschicht 18 und der Oxidschicht 5 soweit entfernt wird, daß der als Cantilever vorgesehene Teil der Sensorschicht 17 freigelegt ist.
Zusammen mit den Anschlußmetallisierungen 16 (s. Fig. 15) kann auch eine obere Sensorelektrode 19 auf die Dielektrikumschicht 18 aufgebracht werden. Diese obere Sensorelektrode 19 wird so bemessen, daß nach dem Entfernen der Dielektrikumschicht 18 im Bereich des Sensors die Sensorschicht 17 zwischen der oberen Sensorelektrode und der weiteren Sensorelektrode 20 frei beweglich ist und die obere Sensorelektrode 19 lateral, d. h. in dem Ausführungsbeispiel in Richtung senkrecht zur Zeichenebene, auf der Dielektrikumschicht 18 verankert ist. Es ist dann bei dem Sensor eine beidseitige kapazitive Messung zwischen der Sensorschicht 17 und je einer Gegenelektrode möglich.

Bei dem Sensor der Fig. 1 ist ein Bipolartransistor in der Substratschicht 1 integriert. Ein dotierter Basisbereich 2 und ein entgegengesetzt dotierter Kollektorbereich 3 sind in der Substratschicht 1 z. B. durch Implantieren ausgebildet, Der vergrabene Kollektorbereich 3 ist mit einem Kollektoranschlußbereich 4 gleichen Vorzeichens der Dotierung mit der Oberfläche der Substratschicht leitend verbunden. Die oberfläche der Substratschicht 1 ist mit einer strukturierten Oxidschicht 5 isoliert. Auf dieser Oxidschicht 5 und auf den Basisbereich 2 reichend befinden sich die Basiselektrode 6 und darauf eine Isolatorschicht 7. Die Basiselektrode 6 ist von der Emitterelektrode 9 durch Spacer 8 elektrisch isoliert. Durch Ausdiffusion aus der Emitterelektrode 9 aus Silizium in den Basisbereich 2 ist unterhalb der Emitterelektrode 9 ein Emitterbereich gebildet. Auf dem Kollektoranschlußbereich 4 befindet sich eine ebenfalls aus Silizium gebildete Kollektorelektrode 10. Im Bereich des Sensors befindet sich auf der Oxidschicht 5 als Fläche eine untere Elektrode 25. Darüber ist hier als Beispiel wieder als Cantilever ausgebildet die Sensorschicht 17 angebracht. Eine Basismetallisierung 11 befindet sich auf der Basiselektrode 6; eine Emittermetallisierung 12 befindet sich auf der Emitterelektrode 9; eine Kollektormetallisierung 13 befindet sich auf der Kollektorelektrode 10. Die untere Sensorelektrode 25 und die Sensorschicht 17 sind jeweils mit einer Metallisierung 14, 15 versehen. Auf diesen Metallisierungen 11, 12, 13, 14, 15 sind die Anschlußmetallisierungen 16 aufgebracht und in eine Dielektrikumschicht 18 eingebettet. Diese Dielektrikumschicht 18 ist in dem als Cantilever vorgesehenen Bereich der Sensorschicht 17 bis auf die untere Sensorelektrode 25 entfernt, so daß der Cantilever in vertikaler Richtung schwingen kann. In der Substratschicht 1 ist ein entgegengesetzt zum Kollektorbereich 3 dotierter Strombegrenzungsbereich 29 (Channel-Stopper) ausgebildet.

In Fig. 2 ist eine alternative Ausführungsform mit oberer Sensorelektrode 19, die in der Dielektrikumschicht 18 verankert ist, dargestellt. Die in dieser Figur 2 eingezeichnete Ansicht (strichpunktierte Linie) ist in Fig. 5 dargestellt. Es sind dort im Schnitt die Metallisierung 14 der unteren Sensorelektrode 25 und die Metallisierung 15 der Sensorschicht 17 eingezeichnet. Die Sensorschicht 17 und die quer dazu angeordnete obere Sensorelektrode 19 sind mit den in der Dielektrikumschicht 18 verankerten Anteile (gestrichelte Linie) dargestellt.

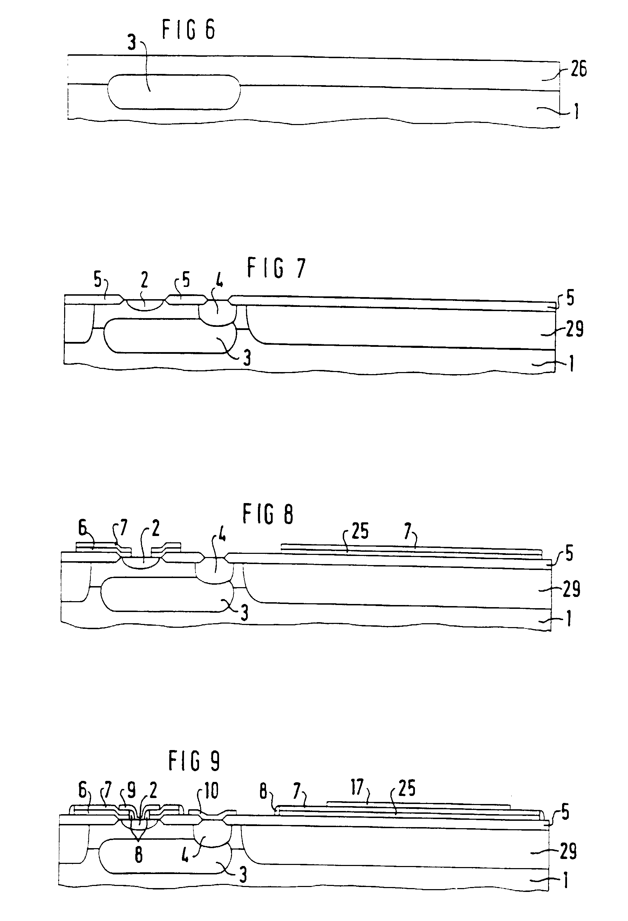

Bei diesem Ausführungsbeispiel des erfindungsgemaßen Verfahrens wird ebenfalls von einer Substratschicht 1 aus Silizium ausgegangen. In dieser Substratschicht 1 wird der Kollektorbereich 3 durch Implantieren hergestellt und anschließend von einer Epitaxieschicht 26 aus Silizium ganzflächig überwachsen, wie in Fig. 6 im Querschnitt dargestellt ist. Nach dem Ausheilen der Implantierung besitzt der Kollektorbereich 3 etwa die in Fig. 6 eingezeichnete Begrenzung. Ggf. erfolgt dann eine Implantation für den Strombegrenzungsbereich 29, wobei das Vorzeichen der Dotierung entgegengesetzt zu dem des Kollektorbereiches 3 ist. Es wird der Basisbereich 2 ebenfalls entgegengesetzt zum Kollektorbereich 3 dotiert hergestellt, wobei zweckmäßig von einer strukturierten oxidschicht 5 als Maske Gebrauch gemacht wird. Diese Oxidschicht 5 kann z. B. durch strukturierte Oxidierung der Oberfläche der Substratschicht 1 hergestellt werden. Auf diese in Fig. 7 dargestellte Struktur werden dann ganzflächig eine Polysiliziumschicht und darauf eine Isolatorschicht 7 aufgebracht, die anschließend so strukturiert werden, daß von der Polysiliziumschicht wie in Fig. 8 gezeigt ein Anteil als Basiselektrode 6 und ein Anteil als untere Sensorelektrode 25 übrigbleiben. Diese untere Sensorelektrode 25 befindet sich vollständig auf der Oxidschicht 5 und ist daher von dem Silizium der Substratschicht 1 elektrisch isoliert. Der ebenfalls durch eine Öffnung der Oxidschicht 5 implantierte Kollektoranschlußbereich 4 und ein für den Emitteranschluß vorgesehener Bereich auf dem Basisbereich 2 bleiben frei (s. Fig. 8) Die Polysiliziumschicht wird beim Abscheiden für das Vorzeichen der Leitfähigkeit der Basis dotiert. Z. B. durch konforme Abscheidung eines Oxids mit anschließender anisotroper Rückätzung werden Spacer zur Isolation der Ränder der Basiselektrode 6 hergestellt.

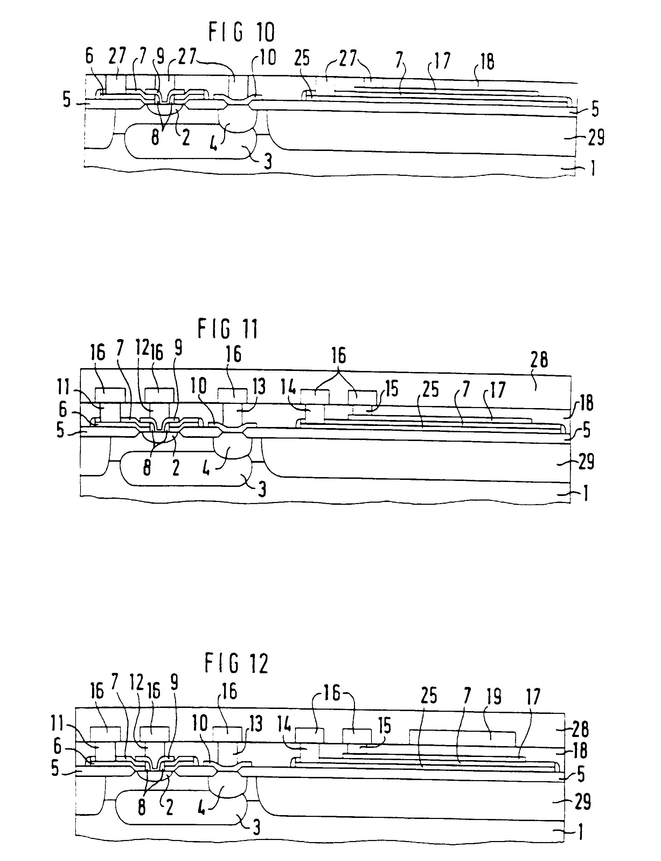

Nach dem Abscheiden einer ganzflächigen Polysiliziumschicht und anschließendem Strukturieren dieser Polysiliziumschicht bleiben als Anteile davon die Emitterelektrode 9 zwischen diesen die Basiselektrode 6 isolierenden Spacer 8, die Kollektorelektrode 10 und eine Sensorschicht 17 auf dem die untere Sensorelektrode 25 isolierenden Anteil der Isolatorschicht 7 übrig. In der Fig. 9 ist erkennbar, daß die untere Sensorelektrode 25 und diese Sensorschicht 17 koplanar vertikal bezüglich der Schicht ebenen übereinander angeordnet und durch die dazwischen befindliche Isolatorschicht 7 gegeneinander isoliert sind. Es wird dann entsprechend Fig. 10 ganzflächig eine Dielektrikumschicht 18 planarisierend abgeschieden und in dieser Dielektrikumschicht 18 an den für elektrische Anschlüsse vorgesehenen Stellen Kontakt löcher 27 hergestellt. Ggf. können diese Kontaktlöcher mit einer Metallfüllung aus z. B. Wolfram aufgefüllt werden, bevor die erste Metallisierungsebene hergestellt wird. Das Auffüllen der Kontaktlöcher 27 kann aber auch in einem Schritt zusammen mit dem Herstellen dieser Anschlußmetallisierung erfolgen. In Fig. 11 sind die Basismetallisierung 11, die Emittermetallisierung 12, die Kollektormetallisierung 13, die Metallisierung 14 für die untere Sensorelektrode 25 und die Metallisierung 15 für die Sensorschicht 17 eingezeichnet. Auf die Metallisierungen wird die Anschlußmetallisierung 16 abgeschieden und strukturiert und mit einer Passivierungsschicht 28 planarisiert. Ggf. kann zusammen mit der Anschlußmetallisierung 16 auch wieder eine obere Sensorelektrode 19 wie in Fig. 12 gezeigt abgeschieden werden. Die Passivierung 28, die Dielektrikumschicht 18 und die Isolatorschicht 7 werden dann im Bereich des Sensors soweit entfernt, wie für eine ausreichende Beweglichkeit des durch die Sensorschicht 17 gebildeten Sensorelementes erforderlich ist.

Die Dielektrikumschichten sind z. B. Oxid, die Passivierungsschicht 28 kann z. B. SiO₂ oder Si₃N₄ sein. Die Anschlußflächen der Anschlußmetallisierung 16 und die Sensorschicht 17 können entweder in einem Arbeitsschritt freigelegt werden oder, falls Ätzstoffe verwendet werden, die keine selektive Ätzung der Passivierungsschicht gleichzeitig relativ zum Metall der Anschlußmetallisierung 16 und zu dem Polysilizium der Sensorschicht 17 zulassen, in zwei aufeinanderfolgenden Fototechnik-Schritten. Die Anschlußmetallisierung 16 und ggf. die obere Sensorelektrode 19 sind z. B. Aluminium.

Vorteilhaft wird das erfindungsgemäße Verfahren zur Herstellung integrierter Beschleunigungssensoren vom Cantilever-Typ angewendet. In gleicher Weise lassen sich aber mikromechanische Sensoren realisieren, bei denen die Sensorschicht 17 z. B. vollständig freigeätzt wird. Auf diese Weise lassen sich z. B. mit dem erfindungsgemaßen Verfahren auch integrierte Sensoren herstellen, bei dem das auf die Trägheitskraft infolge einer Beschleunigung reagierende Element ein an Siliziumfedern aufgehängtes schichtartiges Masseteil ist. Die Dicke der für diese Sensorschicht 17 und die betreffende Transistorelektrode abgeschiedene Polysiliziumschicht muß dann nur für ausreichende mechanische Stabilität dieses Masseteiles bemessen werden. Entsprechend den beschriebenen Ausführungsbeispielen könnten mehrere Transistoren oder komplette elektronische Schaltungen, die wie üblich in Siliziumtechnik realisiert werden, mit dem mikromechanischen Sensor integriert werden. Die für die Herstellung dieser integrierten Schaltungen aufgebrachte Polysiliziumschicht wird jeweils gleichzeitig für die Herstellung des Sensorelementes verwendet und strukturiert. Auch bei Integration mehrerer verschiedener elektronischer Funktionselemente ergibt sich so durch das erfindungsgemäße Verfahren eine Einsparung bei den erforderlichen Prozeßschritten, gegenüber bisher bekannten Verfahren.

## Patentansprüche

1. Verfahren zur Herstellung eines Beschleunigungssensors auf Silizium, bei dem
- in einem ersten Schritt ausgehend von einer Substratschicht (1) aus Silizium eine Struktur dotierter Bereiche zur Ausbildung eines Transistors hergestellt wird,
- in einem zweiten Schritt eine Polysiliziumschicht abgeschieden und derart strukturiert wird, daß diese Polysiliziumschicht mindestens eine Elektrode dieses Transistors und eine Sensorschicht (17) bildet,
- in einem dritten Schritt Metallisierungen (11, 12, 13, 14, 15; 24) als elektrische Anschlüsse für diesen Transistor, für diese Sensorschicht (17) und mindestens eine weitere Sensorelektrode (20; 25) aufgebracht werden und
- in einem vierten Schritt diese Sensorschicht (17) soweit freigelegt wird, daß sie zumindest teilweise in mindestens einer Richtung beweglich ist.

2. Verfahren nach Anspruch 1, bei dem
der Transistor als CMOS-Transistor hergestellt wird und die Polysiliziumschicht die Gateelektrode (23) und die Sensorschicht (17) bildet.

3. Verfahren nach Anspruch 1, bei dem
- der Transistor als Bipolartransistor hergestellt wird, bei dem
- zwischen dem ersten und dem zweiten Schritt eine weitere Polysiliziumschicht abgeschieden und derart strukturiert wird, daß diese weitere Polysiliziumschicht die Basiselektrode (6) und eine untere Sensorelektrode (25) bildet, und dann eine Isolatorschicht (7) und Spacer (8) aufgebracht werden und bei dem
- die in dem zweiten Schritt aufgebrachte Polysiliziumschicht die Emitterelektrode (9), die Kollektorelektrode (10) und die Sensorschicht (17) bildet.

4. Verfahren nach Anspruch 2, bei dem
- in dem ersten Schritt ein für den Transistor vorgesehener dotierter Bereich (CMOS-Wanne) in der Substratschicht (1) und eine strukturierte Oxidschicht (5) auf der Oberfläche der Substratschicht (1) hergestellt werden und dann die Source- und Drain-Bereiche (21) und das Gateoxid (22) in Öffnungen dieser Oxidschicht (5) hergestellt werden,
- in dem zweiten Schritt die Sensorschicht (17) auf einem Anteil dieser Oxidschicht (5) hergestellt wird,
- in dem dritten Schritt eine Dielektrikumschicht (18) aufgebracht wird, darin Kontakt löcher hergestellt werden und die Source- und Drain-Metallisierungen (24) und die Metallisierungen (14, 15) für die Sensorschicht (17) und für eine weitere Sensorelektrode (20) in diese Kontaktlöcher eingebracht werden und
- in dem vierten Schritt diese Dielektrikumschicht (18) und diese Oxidschicht (5) soweit entfernt werden, wie für die vorgesehene Beweglichkeit der Sensorschicht (17) erforderlich ist.

5. Verfahren nach Anspruch 3, bei dem
- in dem ersten Schritt eine Implantierung zur Herstellung eines Kollektorbereiches (3) vorgenommen wird und eine dotierte Epitaxieschicht (26) aufgebracht wird,
dann eine strukturierte Oxidschicht (5) hergestellt wird,
dann durch die Öffnungen dieser Oxidschicht (5) ein entgegengesetzt zu dieser Epitaxieschicht (26) dotierter Basisbereich (2) und ein Kollektoranschlußbereich (4) hergestellt werden,
dann die weitere Polysiliziumschicht und darauf eine Isolatorschicht (7) aufgebracht und strukturiert werden, so daß die untere Sensorelektrode (25) auf dieser Oxidschicht (5) angeordnet ist,
dann freie Ränder der Basiselektrode (6) durch Spacer (8) isoliert werden und
dann der zweite Schritt ausgeführt wird.

6. Verfahren nach einem der Ansprüche 1 bis 5, bei dem in dem vierten Schritt die Sensorschicht (17) als freitragender Polysiliziumstreifen (Cantilever) hergestellt wird.

7. Verfahren nach einem der Ansprüche 1 bis 5, bei dem in dem vierten Schritt die Sensorschicht (17) als an Federn aufgehängtes Masseteil hergestellt wird.

8. Verfahren nach einem der Ansprüche 1 bis 7, bei dem die weitere Sensorelektrode (20; 25) und die Sensorschicht (17) koplanar und bezüglich der Schichtebenen vertikal zueinander übereinander angeordnet werden.

9. Verfahren nach einem der Ansprüche 1 bis 8, bei dem nach dem dritten Schritt koplanar und bezüglich der Schichtebenen vertikal über der Sensorschicht (17) eine ebene obere Sensorelektrode (19) hergestellt wird.

## Claims

1. Process for the production of an acceleration sensor on silicone, in which
- in a first step, starting from a silicone substrate layer (1), a structure of doped regions is produced in order to form a transistor,
- in a second step, a polysilicon layer is deposited and structured in such a way that this polysilicon layer forms at least one electrode of this transistor, as well as a sensor layer (17),
- in a third step, metallisations (11, 12, 13, 14, 15; 24) as electrical connections for this transistor, for this sensor layer (17) and at least one further sensor electrode (20; 25) are applied, and
- in a fourth step, this sensor layer (17) is exposed until it is at least partially mobile in at least one direction.

2. Process according to Claim 1, in which the transistor is produced as a CMOS transistor and the polysilicon layer forms the gate electrode (23) on the layer (17).

3. Process according to Claim 1, in which
- the transistor is produced as a bipolar transistor, in which
- a further polysilicon layer is deposited between the first and second steps and is structured in such a way that this further polysilicon layer forms the base electrode (6) and a lower sensor electrode (25), and then an insulator layer (17) and spacers (8) are applied, and in which
- the polysilicon layer applied in the second step forms the emitter electrode (9), the collector electrode (10) and the sensor layer (17).

4. Process according to Claim 2, in which
- in the first step, a doped region ((CMOS well) intended for the transistor is produced in the substrate layer (1) and a structured oxide layer (5) is produced on the surface of the substrate layer (1), and the source and drain regions (21) and the gate oxide (22) are then produced in openings of this oxide layer (5),
- in the second step, the sensor layer (17) is produced on a portion of this oxide layer (5),
- in the third step, a dielectric layer (18) is applied, contact holes are produced in it and the source and drain metallisations (24) and the metallisations (14, 15) for the sensor layer (17) and for a further sensor electrode (20) are introduced into these contact holes, and
- in the fourth step, this dielectric layer (18) and this oxide layer (5) are removed to the extent required for the intended mobility of the sensor layer (17).

5. Process according to Claim 3, in which
- in the first step, implantation is carried out to produce a collector region (3), and a doped epitaxial layer (26) is applied,
then a structured oxide layer (5) is produced,
then through the openings of this oxide layer (5), a base region (2) oppositely doped to this epitaxial layer (26) and a collector connect region (4) are produced,
then the further polysilicon layer and, on top of it, an insulator layer (7) are applied and structured so that the lower sensor electrode (25) is arranged on this oxide layer (5),
- then free edges of the base electrode (6) are insulated by spacers (8), and
then the second step is carried out.

6. Process according to one of Claims 1 to 5 in which, in the fourth step, the sensor layer (17) is produced as a polysilicon cantilever.

7. Process according to one of Claims 1 to 5 in which, in the fourth step, the sensor layer (17) is produced as a mass part suspended from springs.

8. Process according to one of Claims 1 to 7, in which the further sensor electrode (20; 25) and the sensor layer (17) are arranged coplanar and, in relation to the layer planes, vertically above one another.

9. Process according to one of Claims 1 to 8, in which, after the third step, a planar upper sensor electrode (19) is produced, coplanar and vertically above the sensor layer (17) in relation to the layer planes.

## Revendications

1. Procédé pour la fabrication d'un détecteur d'accélération sur du silicium, dans lequel :
- dans une première étape, en partant d'une couche de substrat (1) en silicium, on crée une structure de zones dopées pour la réalisation d'un transistor,
- dans une deuxième étape, une couche de polysilicium est déposée et structurée de telle manière que cette couche de polysilicium constitue au moins une électrode de ce transistor et une couche de détecteur (17),
- dans une troisième étape, des métallisations (11, 12, 13, 14, 15 ; 24) sont appliquées pour cette couche de détecteur (17) et au moins une électrode de détecteur (20 ; 25) supplémentaire en tant que connexions électriques pour ce transistor, et
- dans une quatrième étape, cette couche de détecteur (17) est dégagée à tel point qu'elle est du moins partiellement mobile dans au moins une direction.

2. Procédé selon la revendication 1, dans lequel le transistor est réalisé en tant que transistor CMOS et la couche de polysilicium constitue l'électrode de grille (23) et la couche de détecteur (17).

3. Procédé selon la revendication 1, dans lequel
- le transistor est réalisé en tant que transistor bipolaire, dans lequel
- une couche de polysilicium supplémentaire est déposée entre la première et la deuxième étape, et structurée de telle manière que cette couche de polysilicium supplémentaire constitue l'électrode de base (6) et une électrode de détecteur inférieure (25), et ensuite une couche d'isolateur (7) et des entretoises (8) sont mises en place, et dans lequel
- la couche de polysilicium appliquée dans la deuxième étape constitue l'électrode d'émetteur (9), l'électrode de collecteur (10) et la couche de détecteur (17).

4. Procédé selon la revendication 2, dans lequel
- dans la première étape, une zone dopée (auge CMOS) prévue pour le transistor est réalisée dans la couche de substrat (1) et une couche d'oxyde structurée (5) à la surface de la couche de substrat (1), et ensuite les zones de source et de drain (21) et l'oxyde de grille (22) sont créées dans des ouvertures de cette couche d'oxyde (5),
- dans la deuxième étape, la couche de détecteur (17) est réalisée sur une portion de cette couche d'oxyde (5),
- dans la troisième étape, une couche diélectrique (18) est appliquée, des orifices de contact y sont pratiqués, et les métallisations de source et de drain (24) et les métallisations (14, 15) pour la couche de détecteur (17) et pour une électrode de détecteur supplémentaire (20) sont intégrées dans ces orifices de contact, et
- dans la quatrième étape, cette couche diélectrique (18) et cette couche d'oxyde (5) sont enlevées dans la mesure nécessaire pour la mobilité prévue de la couche de détecteur (17).

5. Procédé selon la revendication 3, dans lequel
- dans la première étape, une implantation est effectuée pour la réalisation d'une zone de collecteur (3), et une couche épitaxiale dopée (26) est appliquée,
puis une couche d'oxyde structurée (5) est réalisée, puis une zone de la base (2) dopée en sens inverse à cette couche épitaxiale (26) et une zone de borne de collecteur (4) sont créées par les ouvertures de cette couche d'oxyde (5),
puis la couche de polysilicium supplémentaire, et sur celle-ci une couche d'isolateur (7), sont appliquées et structurées de telle façon que l'électrode de détecteur inférieure (25) est installée sur cette couche d'oxyde (5),
puis des bords libres de l'électrode de base (6) sont isolés par des entretoises (8), et
ensuite la deuxième étape est effectuée.

6. Procédé selon l'une des revendications 1 à 5, dans lequel la couche de détecteur (17) est réalisée en tant que bande de polysilicium en porte-à-faux (cantilever) durant la quatrième étape.

7. Procédé selon l'une des revendications 1 à 5, dans lequel la couche de détecteur (17) est réalisée en tant qu'élément de masse suspendu à des ressorts durant la quatrième étape.

8. Procédé selon l'une des revendications 1 à 7, dans lequel l'électrode de détecteur supplémentaire (20 ; 25) et la couche de détecteur (17) sont disposées de manière coplanaire, en ce qui concerne les niveaux de couches, verticalement l'une au-dessus de l'autre.

9. Procédé selon l'une des revendications 1 à 8, dans lequel, après la troisième étape, une électrode de détecteur supérieure (19) plane est réalisée de manière coplanaire et en ce qui concerne les niveaux de couches verticalement au-dessus de la couche de détecteur (17).
